# FASCICULE DE BREVET EUROPEEN

(11) **EP 2 552 023 B1**
(45) Date de publication et mention de la délivrance du brevet: **12.03.2014**
(21) Numéro de dépôt: 12177903.7
(22) Date de dépôt: 25.07.2012
(51) Int. Cl.: H03K 17/96, F24C 7/08

(54) **Dispositif de commande d'un appareil électroménager comprenant un commutateur optique à touche tactile**
Vorrichtung zur Steuerung eines Elektrohaushaltsgeräts, das mit einem optischen Schalter mit berührungsempfindlicher Taste ausgestattet ist
Control device of a household appliance comprising an optical touch-sensitive switch

(30) Priorité: 26.07.2011 FR 1102357
(43) Date de publication de la demande: 30.01.2013
(73) Titulaire: FagorBrandt SAS, 92500 Rueil-Malmaison (FR)
(72) Inventeur: Andre, Xavier, 45380 La Chapelle Saint Mesmin (FR); Gouardo, Didier, 45520 Cercottes (FR); Barjolin, Nicolas, 45140 SAINT JEAN DE LA RUELLE (FR); Nugeyre, Jean-Pierre, 45370 CLERY SAINT ANDRE (FR)

(56) Documents cités:
- WO-A1-03/076870
- US-A1- 2005 218 306
- US-B2- 6 828 546

## Description

La présente invention concerne un dispositif de commande d'un appareil électroménager.

De manière générale, elle concerne un appareil électroménager ayant un clavier de commande.

On connaît déjà des dispositifs de commande d'un appareil électroménager comprenant un commutateur optique à touche tactile, une paroi étant au moins partiellement transparente à un rayonnement infrarouge. Le commutateur optique est disposé derrière la paroi au moins partiellement transparente à un rayonnement infrarouge. Le commutateur optique comprend un émetteur émettant un rayonnement infrarouge, un émetteur auxiliaire émettant un rayonnement infrarouge, et un récepteur recevant au moins en partie un rayonnement infrarouge émis par l'émetteur et au moins en partie un rayonnement infrarouge émis par l'émetteur auxiliaire. Le récepteur génère au moins un signal de réception en fonction du rayonnement infrarouge reçu depuis l'émetteur et/ou depuis l'émetteur auxiliaire. L'émetteur et le récepteur sont disposés dans un cache. Le cache comprend une paroi de séparation ménagée entre l'émetteur et le récepteur, des parois périphériques ménagées autour de l'émetteur et du récepteur. L'émetteur auxiliaire est disposé en dehors du cache comportant l'émetteur et le récepteur.

Le document US6828546 B2 divulgue un exemple de commutateur optique comprenant un émetteur, un récepteur et un émetteur auxiliaire.

Cependant, des dispositifs de commande d'un appareil électroménager ayant les parois périphériques du cache ménagées autour de l'émetteur et du récepteur pleines sur toute leur surface présentent l'inconvénient d'empêcher le rayonnement infrarouge émis par l'émetteur auxiliaire d'atteindre latéralement le récepteur.

Par conséquent, ces dispositifs de commande d'un appareil électroménager ne permettent pas de tester efficacement le fonctionnement de la chaîne d'acquisition d'un commutateur optique à touche tactile au moyen de l'émetteur auxiliaire depuis le récepteur jusqu'à un dispositif de conversion analogique / numérique d'une unité de commande comprenant par exemple un microcontroleur, et en particulier de détecter un dysfonctionnement du commutateur optique à touche tactile.

Par ailleurs, des dispositifs de commande d'un appareil électroménager sans paroi périphérique du cache ménagée entre le récepteur et l'émetteur auxiliaire présentent l'inconvénient de laisser passer un rayonnement lumineux trop important depuis une source de lumière extérieure au dispositif de commande pour détecter un appui d'un doigt d'un utilisateur sur le commutateur optique à touche tactile, en particulier lorsque le rayonnement lumineux émis par la source de lumière extérieure atteint latéralement le récepteur.

Cette source de lumière extérieure au dispositif de commande peut être par exemple le soleil, ou encore un dispositif d'éclairage de la pièce dans laquelle se situe l'appareil électroménager.

La présente invention a pour but de résoudre les inconvénients précités et de proposer un dispositif de commande d'un appareil électroménager permettant de sécuriser le fonctionnement d'un commutateur optique à touche tactile ayant au moins un émetteur auxiliaire tout en garantissant la détection d'un appui sur le commutateur optique à touche tactile quelles que soient les conditions de luminosité extérieures au dispositif de commande.

A cet effet, la présente invention vise, selon un premier aspect, un dispositif de commande d'un appareil électroménager comprenant :
- au moins un commutateur optique à touche tactile,
- une paroi étant au moins partiellement transparente à un rayonnement infrarouge ;
ledit au moins un commutateur optique à touche tactile étant disposé derrière ladite paroi au moins partiellement transparente à un rayonnement infrarouge ;
ledit au moins un commutateur optique à touche tactile comprenant :
- au moins un émetteur émettant un rayonnement infrarouge,
- au moins un émetteur auxiliaire émettant un rayonnement infrarouge, et
- au moins un récepteur recevant au moins en partie un rayonnement infrarouge émis par ledit au moins un émetteur et au moins en partie un rayonnement infrarouge émis par ledit au moins un émetteur auxiliaire ;
ledit au moins un récepteur générant au moins un signal de réception en fonction du rayonnement infrarouge reçu depuis ledit au moins un émetteur et/ou depuis ledit au moins un émetteur auxiliaire ;
ledit au moins un émetteur et ledit au moins un récepteur étant disposés dans un cache ;
ledit cache comprenant :
- une paroi de séparation ménagée entre ledit au moins un émetteur et ledit au moins un récepteur,
- des parois périphériques ménagées autour dudit au moins un émetteur et dudit au moins un récepteur.

Selon l'invention, l'une des parois périphériques dudit cache ménagée entre ledit au moins un récepteur et ledit au moins un émetteur auxiliaire formant une cloison de séparation comprend au moins une ouverture de passage d'au moins une partie du rayonnement infrarouge émis par ledit au moins un émetteur auxiliaire vers ledit au moins un récepteur de sorte à déterminer un dysfonctionnement dudit au moins un commutateur optique à touche tactile en fonction dudit au moins un signal de réception reçu par ledit au moins un récepteur depuis ledit au moins un émetteur auxiliaire.

Ainsi, la paroi périphérique du cache ménagée entre ledit au moins un récepteur et ledit au moins un émetteur auxiliaire comprenant au moins une ouverture de passage d'au moins une partie du rayonnement infrarouge émis par ledit au moins un émetteur auxiliaire vers ledit au moins un récepteur permet de tester le fonctionnement d'au moins un commutateur optique à touche tactile au moyen dudit au moins un émetteur auxiliaire tout en garantissant la détection d'un appui sur ledit au moins un commutateur optique à touche tactile quelles que soient les conditions de luminosité extérieures au dispositif de commande.

En outre, la paroi périphérique du cache ménagée entre ledit au moins un récepteur et ledit au moins un émetteur auxiliaire pourvue de ladite au moins une ouverture de passage permet d'améliorer l'immunité au bruit ambiant du dispositif de commande liée à un fort éclairement, en particulier lorsqu'un doigt d'un utilisateur est positionné au-dessus dudit au moins un commutateur optique à touche tactile.

Par conséquent, la paroi périphérique du cache ménagée entre ledit au moins un récepteur et ledit au moins un émetteur auxiliaire pourvue de ladite au moins une ouverture de passage permet de s'affranchir des nuisances provoquées par un fort éclairement provenant d'une source de lumière extérieure au dispositif de commande dirigé latéralement par rapport audit au moins un récepteur, où la source de lumière extérieure peut être par exemple le soleil ou un dispositif d'éclairage de la pièce dans laquelle se situe l'appareil électroménager.

Selon une caractéristique préférée de l'invention, ladite au moins une ouverture de passage de ladite paroi périphérique dudit cache s'étend entre une plaquette de circuit imprimé et un rebord de ladite paroi périphérique dudit cache ménagée entre ledit au moins un récepteur et ledit au moins un émetteur auxiliaire, ladite plaquette de circuit imprimé supportant ledit au moins un commutateur optique à touche tactile.

Ainsi, ladite au moins une ouverture de passage de la paroi périphérique du cache ménagée entre ledit au moins un récepteur et ledit au moins un émetteur auxiliaire s'étend sur une partie de la hauteur de cette paroi périphérique du cache.

De cette manière, ladite au moins une ouverture de passage de la paroi périphérique du cache ménagée entre ledit au moins un récepteur et ledit au moins un émetteur auxiliaire s'étend uniquement sur la partie inférieure de cette paroi périphérique du cache.

En outre, ladite au moins une ouverture de passage de la paroi périphérique du cache ménagée entre ledit au moins un récepteur et ledit au moins un émetteur auxiliaire permet de laisser passer au moins une partie du rayonnement infrarouge émis par ledit au moins un émetteur auxiliaire vers ledit au moins un récepteur, et ladite paroi périphérique du cache ménagée entre ledit au moins un récepteur et ledit au moins un émetteur auxiliaire pourvue de ladite au moins une ouverture de passage bloque les rayons lumineux provenant d'une source de lumière extérieure au dispositif de commande dirigés latéralement par rapport audit au moins un récepteur.

La présente invention concerne également, selon un second aspect, un appareil électroménager, notamment une table de cuisson domestique, comprenant un dispositif de commande décrit précédemment.

Cet appareil électroménager présente des avantages et caractéristiques analogues à ceux décrits précédemment en relation avec le dispositif de commande selon l'invention.

D'autres particularités et avantages de l'invention apparaîtront encore dans la description ci-après.

Aux dessins annexés, donnés à titre d'exemples non limitatifs :
- la figure 1 est une vue schématique de dessus d'une table de cuisson comprenant un dispositif de commande selon un mode de réalisation de l'invention ;
- la figure 2 est une vue schématique éclatée d'un dispositif de commande d'un appareil électroménager selon un mode de réalisation de l'invention ;
- la figure 3 est une vue schématique assemblée et en perspective d'un dispositif de commande d'un appareil électroménager de la figure 2 ; et
- la figure 4 est une vue schématique en coupe d'un dispositif de commande d'un appareil électroménager selon un mode de réalisation de l'invention.

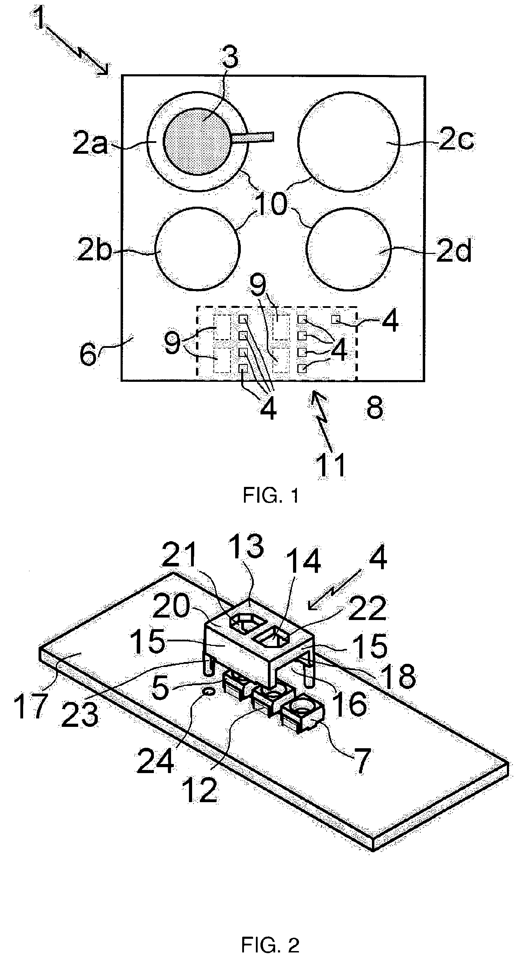

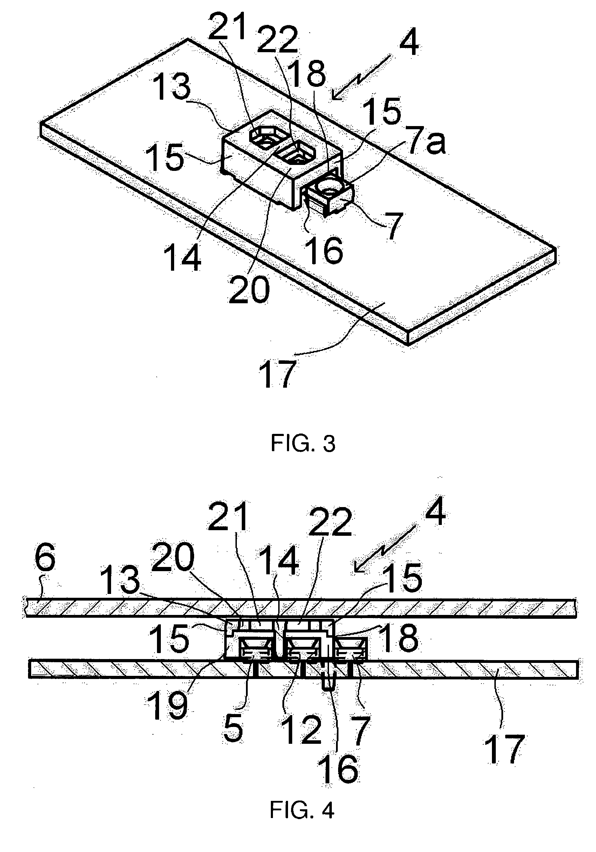

On va décrire, en référence aux figures 1 à 4, un appareil électroménager comprenant un dispositif de commande conforme à un mode de réalisation de l'invention.

Cet appareil électroménager peut être un appareil de cuisson, en particulier une table de cuisson à usage domestique, un four de cuisson à usage domestique ou une cuisinière, ou un appareil de lavage, en particulier une machine à laver et/ou à sécher le linge à usage domestique, ou une machine à laver la vaisselle à usage domestique, ou un appareil de réfrigération, en particulier un réfrigérateur ou un congélateur.

Ici, de manière non limitative, l'appareil électroménager est une table de cuisson 1.

On a illustré sur la figure 1 une vue schématique de dessus d'une table de cuisson 1. Des cercles 10 schématisent l'existence de foyers de cuisson 2a, 2b, 2c, 2d sur lesquels un récipient de cuisson 3 peut être posé.

Ici et de manière nullement limitative, la table de cuisson 1 comprend quatre foyers de cuisson 2a, 2b, 2c, 2d indépendants.

Bien entendu, le nombre de foyers de cuisson 2a, 2b, 2c, 2d n'est nullement limitatif et la disposition de ceux-ci peut être différente.

Une telle table de cuisson peut être encastrée ou faire partie intégrante d'un plan de travail. Elle peut également être associée à d'autres appareils de cuisson, tel qu'un four de cuisson disposé en dessous.

Chaque foyer de cuisson 2a, 2b, 2c, 2d comprend au moins un moyen de chauffage.

Le ou les moyens de chauffage de chacun desdites foyers de cuisson 2a, 2b, 2c, 2d peut être alimenté en électricité et/ou au gaz. Ces moyens de chauffage peuvent être du type à induction, radiant ou halogène, ou encore au gaz.

Ici, chaque foyer de cuisson 2a, 2b, 2c, 2d est constitué d'un ou plusieurs éléments chauffant.

Ainsi, un élément chauffant unique peut matérialiser chaque foyer de cuisson 2a, 2b, 2c, 2d.

Alternativement, chaque foyer de cuisson 2a, 2b, 2c, 2d peut comporter plusieurs éléments chauffant.

Dans un mode de réalisation, la disposition de la pluralité des éléments chauffant peut être concentrique et comporter par exemple deux ou trois éléments chauffant permettant d'adapter la taille du foyer de cuisson à la taille du récipient à chauffer.

Dans un mode de réalisation, la disposition de la pluralité des éléments chauffant peut être adjacente, en particulier soit en ligne, soit en triangle, soit en carré, et comporter par exemple entre deux et quatre éléments chauffant permettant d'adapter la taille du foyer de cuisson à la taille du récipient à chauffer.

Dans un autre mode de réalisation, la disposition des éléments chauffant peut être réalisée sous la forme d'une matrice de sorte à former un plan de cuisson sans zones de chauffe prédéterminées.

Dans l'exemple de réalisation illustré à la figure 1, la table de cuisson 1 comprend un plan de cuisson 6, en particulier en vitrocéramique. Cette table de cuisson 1 comprend dans le plan de cuisson 6 plusieurs foyers de cuisson 2a, 2b, 2c, 2d.

Ces foyers de cuisson 2a, 2b, 2c, 2d peuvent dans un mode réalisation tel qu'illustré à la figure 1 être constitués par un ou plusieurs inducteurs permettant de chauffer un récipient de cuisson 3 par le principe de chauffage par induction.

La table de cuisson 1 comprend un dispositif de commande à touches tactiles 11 tel qu'illustré à la figure 1.

Le dispositif de commande à touches tactiles 11 est placé de préférence sous la forme d'un bandeau de commande à proximité d'un bord frontal de la table de cuisson 1.

Ici, le dispositif de commande à touches tactiles 11 est placé sous le plan de cuisson 6.

Bien entendu, lorsque l'appareil électroménager présente une structure différente, au moins la partie du bandeau de commande comportant le dispositif de commande à touches tactiles décrit ci-après peut être réalisé à partir d'une plaque en matériau au moins partiellement transparente à un rayonnement infrarouge, et par exemple en verre ou en plastique.

Le dispositif de commande 11 d'un appareil électroménager 1 comprend au moins un commutateur optique à touche tactile 4, une paroi 6 étant au moins partiellement transparente à un rayonnement infrarouge.

Ledit au moins un commutateur optique à touche tactile 4 est disposé derrière la paroi 6 au moins partiellement transparente à un rayonnement infrarouge.

Dans un mode de réalisation, le dispositif de commande à touches tactiles 11 peut comprendre une pluralité de commutateurs optique à touche tactile 4 indépendants les uns des autres et situés sous une paroi 6 du dispositif de commande 11.

Les commutateurs optique à touche tactile 4 sont associés à des moyens de détection de la présence d'un objet, en particulier d'un doigt d'un utilisateur, en regard de ces commutateurs optique à touche tactile 4.

Ledit au moins un commutateur optique à touche tactile 4 comprend au moins un émetteur 5 émettant un rayonnement infrarouge, au moins un émetteur auxiliaire 7 émettant un rayonnement infrarouge, et au moins un récepteur 12 recevant au moins en partie un rayonnement infrarouge émis par ledit au moins un émetteur 5 et au moins en partie un rayonnement infrarouge émis par ledit au moins un émetteur auxiliaire 7.

Ici et de manière nullement limitative, ledit au moins un émetteur 5 et ledit au moins un émetteur auxiliaire 7 sont des diodes électroluminescentes. Et ledit au moins un récepteur 12 est un phototransistor.

Les moyens de détection associés audit au moins un commutateur à touche tactile 4 sont adaptés à détecter la variation de l'éclairement, en particulier lorsqu'un objet pouvant être un doigt d'un utilisateur, est placé en regard et/ou déplacé en vis-à-vis dudit au moins un commutateur optique à touche tactile 4.

Ledit au moins un commutateur optique à touche tactile 4 permet ainsi de fournir des signaux de détection à partir desquels le déclenchement d'une fonction de commande ou le réglage d'une valeur d'au moins un paramètre de fonctionnement peuvent être réalisés.

Ledit au moins un récepteur 12 génère au moins un signal de réception en fonction du rayonnement infrarouge reçu depuis ledit au moins un émetteur 5 et/ou depuis ledit au moins un émetteur auxiliaire 7.

Le dispositif de commande à touches tactiles 11 comprend également une unité de commande (non représentée) générant au moins un signal de commande en fonction du positionnement ou du déplacement d'un objet à proximité dudit au moins un commutateur optique à touche tactile 4 de sorte à déclencher une fonction de commande ou à régler une valeur d'un paramètre de fonctionnement variable.

Ici, la fonction de commande à déclencher au moyen dudit au moins un commutateur optique à touche tactile 4 est la fonction de marche/arrêt d'un appareil électroménager 1.

Ainsi, une ouverture de passage 16 d'au moins une partie du rayonnement infrarouge émis par un émetteur auxiliaire 7 vers un récepteur 12 ménagée dans l'une des parois périphériques 15 du cache 13 disposée entre le récepteur 12 et l'émetteur auxiliaire 7 permet de sécuriser le fonctionnement d'un commutateur optique à touche tactile 4 et de garantir la mise en fonctionnement et en particulier l'arrêt d'un appareil électroménager 1.

De cette manière, la détection d'une défaillance par le dispositif de commande à touches tactiles 11 permet d'arrêter automatiquement par sécurité l'appareil électroménager 1, ainsi que, par exemple, des moyens de chauffage mis en fonctionnement par l'unité de commande de l'appareil électroménager 1 pouvant être notamment une table de cuisson.

Bien entendu, la fonction de commande à déclencher au moyen dudit au moins un commutateur optique à touche tactile n'est nullement limitative et peut être différente, en particulier la fonction de commande à déclencher au moyen dudit au moins un commutateur optique à touche tactile peut être une fonction de validation d'un paramètre de fonctionnement sélectionné.

Dans un mode de réalisation, un paramètre de fonctionnement variable à régler au moyen dudit au moins un commutateur optique à touche tactile 4 peut être la puissance de chauffe d'un récipient, ou une minuterie pouvant être associée à un foyer de cuisson.

Bien entendu, dans d'autres types d'appareil électroménager, le paramètre de fonctionnement variable à régler au moyen dudit au moins un commutateur optique à touche tactile 4 peut être différent. Il peut être en particulier un paramètre de température, associé à une sonde de température de l'appareil électroménager, notamment lorsque celui-ci est un four de cuisson.

Dans le mode de réalisation illustré à la figure 1, le dispositif de commande à touches tactiles 11 de la table de cuisson 1 comprend un clavier de commande 8 généralement disposé sur un côté de la table de cuisson 1, par exemple le long d'un bord avant du plan de cuisson 6.

Ce clavier de commande 8 comprend des moyens de commande 4 en fonctionnement des foyers de cuisson 2a, 2b, 2c, 2d.

Dans ce mode de réalisation, le clavier de commande 8 comprend différents commutateurs optique à touche tactile 4 permettant à l'utilisateur, par simple appui au niveau d'une touche matérialisée par une zone de marquage sur le plan de cuisson 6, de commander et/ou modifier le fonctionnement d'un ou plusieurs foyers de cuisson 2a, 2b, 2c, 2d.

A titre d'exemple nullement limitatif, les zones de marquage des commutateurs optique à touche tactile 4 peut être réalisée par sérigraphie.

Le clavier de commande 8 de la table de cuisson 1 communique avec une unité de commande. Ladite unité de commande est elle-même reliée aux moyens de chauffage de la table de cuisson 1 et éventuellement à des moyens de détection d'un récipient.

L'unité de commande permet ainsi de commander en fonctionnement le ou les moyens de chauffage de chaque foyer de cuisson 2a, 2b, 2c, 2d et éventuellement de commander en fonctionnement les moyens de détection d'un récipient.

L'unité de commande communique avec le clavier de commande 8 pour recevoir dudit clavier de commande 8 les paramètres de fonctionnement d'un ou plusieurs foyers de cuisson 2a, 2b, 2c, 2d commandés par l'utilisateur et pour envoyer des informations audit clavier de commande 8 concernant l'état des foyers de cuisson 2a, 2b, 2c, 2d ainsi que le réglage des paramètres de fonctionnement, tel que par exemple le niveau de puissance et la durée d'une minuterie, et/ou pour afficher des données sur au moins un moyen d'affichage 9 du clavier de commande 8.

Dans un mode de réalisation, ledit au moins un moyen d'affichage 9 peut être un afficheur à sept segments associé à au moins un commutateur optique à touche tactile 4.

Bien entendu, le type d'au moins un moyen d'affichage n'est nullement limitatif et peut être différent, en particulier ledit au moins un moyen d'affichage peut être un afficheur LCD (acronyme du terme anglo-saxon Liquid Crystal Display).

Ledit au moins un émetteur 5 et ledit au moins un récepteur 12 sont disposés dans un cache 13.

Ici et de manière nullement limitative, le cache 13 est de forme sensiblement parallélépipédique.

Le cache 13 comprend une paroi de séparation 14 ménagée entre ledit au moins un émetteur 5 et ledit au moins un récepteur 12, des parois périphériques 15 ménagées autour dudit au moins un émetteur 5 et dudit au moins un récepteur 12.

Préférentiellement, la paroi de séparation 14 du cache 13 ménagée entre ledit au moins un émetteur 5 et ledit au moins un récepteur 12 est pleine.

Ainsi, la paroi de séparation 14 du cache 13 est pleine de sorte à forcer le chemin optique du rayonnement infrarouge émis par ledit au moins un émetteur 5 en direction de la paroi 6, puis à être réfléchi au moins partiellement par la paroi 6 et éventuellement par un doigt de l'utilisateur disposé en vis-à-vis du commutateur optique à touche tactile 4 vers ledit au moins un récepteur 12.

De cette manière, ledit au moins un récepteur 12 reçoit un rayonnement infrarouge indirectement depuis ledit au moins un émetteur 5 au moyen de la paroi de séparation 14 du cache 13 ménagée entre ledit au moins un émetteur 5 et ledit au moins un récepteur 12 de sorte à garantir le fonctionnement d'un commutateur optique à touche tactile 4 et à éviter un dysfonctionnement de celui-ci par un rayonnement infrarouge émis directement depuis ledit au moins un émetteur 5.

Le cache 13 comprend au moins une ouverture 21 ménagée au-dessus dudit au moins un émetteur 5 et au moins une ouverture 22 ménagée au-dessus dudit au moins un récepteur 12.

Lesdites au moins une ouverture 21, 22 du cache 13 sont réalisées en direction de la paroi 6 au moins partiellement transparente à un rayonnement infrarouge.

Préférentiellement, ledit au moins un émetteur auxiliaire 7 est disposé en dehors du cache 13 comportant ledit au moins un émetteur 5 et ledit au moins un récepteur 12.

Ainsi, le cache 13 peut être utilisé pour un commutateur optique à touche tactile 4 pourvu ou non d'au moins un émetteur auxiliaire 7 de sorte à standardiser le cache 13 pour les différents types de commutateur optique à touche tactile.

De cette manière, le cache 13 peut être employé pour un commutateur optique à touche tactile 4 pourvu ou non d'au moins un émetteur auxiliaire 7.

En outre, la surface recouverte par le cache 13 est minimisée de sorte à réduire le coût d'obtention de celui-ci. La dimension de la plaquette de circuit imprimé 17 peut également être réduite de sorte à minimiser son encombrement et à minimiser le coût d'obtention du dispositif de commande 11.

Par ailleurs, un témoin de signalisation associé à un commutateur optique à touche tactile 4 peut être placé à proximité de ce dernier sans être gêné par le cache 13 de sorte à faciliter la visualisation du témoin de signalisation lors de l'activation du commutateur optique à touche tactile 4.

Le positionnement dudit au moins un émetteur auxiliaire 7 en dehors du cache 13 permet également de faciliter l'implantation d'un commutateur optique à touche tactile 4 sur la plaquette de circuit imprimé 17, et en particulier du positionnement dudit au moins un récepteur 12 en regard dudit au moins un émetteur auxiliaire 7.

Selon l'invention, l'une des parois périphériques 15 du cache 13 ménagée entre ledit au moins un récepteur 12 et ledit au moins un émetteur auxiliaire 7 formant une cloison de séparation comprend au moins une ouverture de passage 16 d'au moins une partie du rayonnement infrarouge émis par ledit au moins un émetteur auxiliaire 7 vers ledit au moins un récepteur 12 de sorte à déterminer un dysfonctionnement dudit au moins un commutateur optique à touche tactile 4 en fonction dudit au moins un signal de réception reçu par ledit au moins un récepteur 12 depuis ledit au moins un émetteur auxiliaire 7.

Ainsi, la paroi périphérique 15 du cache 13 ménagée entre ledit au moins un récepteur 12 et ledit au moins un émetteur auxiliaire 7 comprenant au moins une ouverture de passage 16 d'au moins une partie du rayonnement infrarouge émis par ledit au moins un émetteur auxiliaire 7 vers ledit au moins un récepteur 12 permet de tester le fonctionnement d'au moins un commutateur optique à touche tactile 4 au moyen dudit au moins un émetteur auxiliaire 7 tout en garantissant la détection d'un appui sur ledit au moins un commutateur optique à touche tactile 4 quelles que soient les conditions de luminosité extérieures au dispositif de commande 11.

En outre, la paroi périphérique 15 du cache 13 ménagée entre ledit au moins un récepteur 12 et ledit au moins un émetteur auxiliaire 7 pourvue de ladite au moins une ouverture de passage 16 permet d'améliorer l'immunité au bruit ambiant du dispositif de commande 11 liée à un fort éclairement, en particulier lorsqu'un doigt d'un utilisateur est positionné au-dessus dudit au moins un commutateur optique à touche tactile 4.

Par conséquent, la paroi périphérique 15 du cache 13 ménagée entre ledit au moins un récepteur 12 et ledit au moins un émetteur auxiliaire 7 pourvue de ladite au moins une ouverture de passage 16 permet de s'affranchir des nuisances provoquées par un fort éclairement provenant d'une source de lumière extérieure au dispositif de commande 11 dirigé latéralement par rapport audit au moins un récepteur 12, où la source de lumière extérieure peut être par exemple le soleil ou un dispositif d'éclairage de la pièce dans laquelle se situe l'appareil électroménager 1.

Un tel dispositif de commande 11 d'un appareil électroménager 1 permet de sécuriser le fonctionnement d'au moins un commutateur optique à touche tactile 4 en vérifiant le fonctionnement de la chaîne d'acquisition depuis ledit au moins un récepteur 12 jusqu'à un dispositif de conversion analogique / numérique d'une unité de commande, comprenant par exemple un microcontrôleur.

La sécurisation de fonctionnement dudit au moins un commutateur optique à touche tactile 4 est effectuée par au moins un émetteur auxiliaire 7 différent d'au moins un émetteur 5 utilisé pour la détection d'un objet placé en regard et/ou déplacé en vis-à-vis dudit au moins un commutateur optique à touche tactile 4, et au moins un cache 13 logeant ledit au moins un émetteur 5 et ledit au moins un récepteur 12 et comportant au moins une ouverture de passage 16 d'une paroi périphérique 15 du cache 13 ménagée entre ledit au moins un récepteur 12 et ledit au moins un émetteur auxiliaire 7.

Préférentiellement, ladite au moins une ouverture de passage 16 de ladite paroi périphérique 15 du cache 13 s'étend entre une plaquette de circuit imprimé 17 et un rebord 18 de la paroi périphérique 15 du cache 13 ménagée entre ledit au moins un récepteur 12 et ledit au moins un émetteur auxiliaire 7, la plaquette de circuit imprimé 17 supportant ledit au moins un commutateur optique à touche tactile 4.

Ainsi, ladite au moins une ouverture de passage 16 de la paroi périphérique 15 du cache 13 ménagée entre ledit au moins un récepteur 12 et ledit au moins un émetteur auxiliaire 7 s'étend sur une partie de la hauteur de cette paroi périphérique 15 du cache 13.

De cette manière, ladite au moins une ouverture de passage 16 de la paroi périphérique 15 du cache 13 ménagée entre ledit au moins un récepteur 12 et ledit au moins un émetteur auxiliaire 7 s'étend uniquement sur la partie inférieure de cette paroi périphérique 15 du cache 13.

En outre, ladite au moins une ouverture de passage 16 de la paroi périphérique 15 du cache 13 ménagée entre ledit au moins un récepteur 12 et ledit au moins un émetteur auxiliaire 7 permet de laisser passer au moins une partie du rayonnement infrarouge émis par ledit au moins un émetteur auxiliaire 7 vers ledit au moins un récepteur 12, et ladite paroi périphérique 15 du cache 13 ménagée entre ledit au moins un récepteur 12 et ledit au moins un émetteur auxiliaire 7 pourvue de ladite au moins une ouverture de passage 16 bloque les rayons lumineux provenant d'une source de lumière extérieure au dispositif de commande 11 dirigés latéralement par rapport audit au moins un récepteur 12.

Par ailleurs, la partie supérieure de la paroi périphérique 15 du cache 13 comprenant ladite au moins une ouverture de passage 16 étant pleine permet de bloquer les rayons lumineux provenant d'une source de lumière extérieure au dispositif de commande 11 dirigés latéralement par rapport audit au moins un récepteur 12.

De préférence, ledit au moins un émetteur 5, ledit au moins un émetteur auxiliaire 7 et ledit au moins un récepteur 12 sont fixés sur la plaquette de circuit imprimé 17, par exemple par soudage. Et la face inférieure du cache 13 est mise en appui contre la face supérieure de la plaquette de circuit imprimé 17.

Dans un mode de réalisation, le cache 13 comprend au moins deux plots de positionnement 23 s'insérant respectivement dans une ouverture 24 de la plaquette de circuit imprimé 17 de sorte à être positionné et bloqué en rotation par rapport audit au moins un émetteur 5, audit au moins un émetteur auxiliaire 7 et audit au moins un récepteur 12.

Lesdits au moins deux plots de positionnement 23 du cache 13 peuvent être insérés en force respectivement dans une ouverture 24 de la plaquette de circuit imprimé 17 de sorte à garantir la fixation du cache 13 par rapport à la plaquette de circuit imprimé 17.

Pratiquement, la hauteur de ladite au moins une ouverture de passage 16 de la paroi périphérique 15 du cache 16 s'étendant depuis la plaquette de circuit imprimé 17 jusqu'au rebord 18 de la paroi périphérique 15 du cache 13 est supérieure à la hauteur dudit au moins un émetteur auxiliaire 7 s'étendant depuis la plaquette de circuit imprimé 17 jusqu'à la face supérieure 7a dudit au moins un émetteur auxiliaire 7.

Ainsi, ladite au moins une ouverture de passage 16 de la paroi périphérique 15 du cache 13 ménagée entre ledit au moins un récepteur 12 et ledit au moins un émetteur auxiliaire 7 permet de laisser passer au moins une partie du rayonnement infrarouge émis par ledit au moins un émetteur auxiliaire 7 vers ledit au moins un récepteur 12 tout en prenant en compte le cône de diffusion de rayonnement infrarouge dudit au moins un émetteur auxiliaire 7.

La partie supérieure de la paroi périphérique 15 du cache 13 comprenant ladite au moins une ouverture de passage 16 étant pleine permet de bloquer les rayons lumineux provenant d'une source de lumière extérieure au dispositif de commande 11 dirigés latéralement par rapport audit au moins un récepteur 12.

A titre d'exemple nullement limitatif, la hauteur de ladite au moins une ouverture de passage 16 de la paroi périphérique 15 du cache 13 est inférieure à 2,5mm, et préférentiellement de l'ordre de 2,3mm.

La hauteur de ladite au moins une ouverture de passage 16 de la paroi périphérique 15 du cache 13 est fonction notamment de la hauteur dudit au moins un émetteur auxiliaire 7 et du cône de diffusion de rayonnement infrarouge dudit au moins un émetteur auxiliaire 7.

Dans un mode de réalisation, ladite au moins une ouverture de passage 16 de la paroi périphérique 15 du cache 13 s'étend entre deux autres parois périphériques 15 opposées du cache 13.

La largeur de ladite au moins une ouverture de passage 16 de la paroi périphérique 15 du cache 13 correspond à la distance séparant les deux autres parois périphériques 15 opposées du cache 13.

Ainsi, ladite au moins une ouverture de passage 16 de la paroi périphérique 15 du cache 13 ayant une largeur maximale permet de laisser passer un rayonnement infrarouge maximum depuis ledit au moins un émetteur auxiliaire 7 vers ledit au moins un récepteur 12.

De préférence, les deux autres parois périphériques 15 opposées du cache 13 entre lesquelles s'étend ladite au moins une ouverture de passage 16 de la paroi périphérique 15 du cache 13 sont pleines et s'étendent depuis la plaquette de circuit imprimé 17 jusqu'à la face supérieure du cache 13.

Avantageusement, l'épaisseur e de la paroi périphérique 15 du cache 15 comportant ladite au moins une ouverture de passage 16 est inférieure à 1 mm, et préférentiellement de l'ordre de 0,6mm.

Ainsi, la paroi périphérique 15 du cache 15 comportant ladite au moins une ouverture de passage 16 ayant une épaisseur réduite permet de laisser passer un rayonnement infrarouge maximum depuis ledit au moins un émetteur auxiliaire 7 vers ledit au moins un récepteur 12 tout en bloquant les rayons lumineux provenant d'une source de lumière extérieure au dispositif de commande 11 dirigés latéralement par rapport audit au moins un récepteur 12.

Préférentiellement, les autres parois périphériques 15 du cache 13 ménagées entre ledit au moins un récepteur 12 et ledit au moins un émetteur auxiliaire 7 sont pleines.

Dans un mode de réalisation, l'une des parois périphériques 15 du cache 13 ménagée autour dudit au moins un émetteur 5 formant une cloison de séparation comprend également au moins une ouverture de passage 19 disposée symétriquement par rapport à ladite au moins une ouverture de passage 16 de la paroi périphérique 15 du cache 13 ménagée entre ledit au moins un récepteur 12 et ledit au moins un émetteur auxiliaire 7.

Ainsi, le cache 13 est symétrique et comporte de part et d'autre de la paroi de séparation 14 ménagée entre ledit au moins un émetteur 5 et ledit au moins un récepteur 12 au moins une ouverture de passage 16, 19 ménagée dans une paroi périphérique 15 de sorte à éviter une erreur d'assemblage du support 13 sur la plaquette de circuit imprimé 17 pouvant obstruée le passage d'au moins une partie du rayonnement infrarouge depuis ledit au moins un émetteur auxiliaire 7 vers ledit au moins un récepteur 12 par une paroi périphérique 15 pleine du support 13.

De préférence, ladite au moins une ouverture de passage 19 ménagée dans l'une des parois périphériques 15 du cache 13 autour dudit au moins un émetteur 5 et ladite au moins une ouverture de passage 16 de la paroi périphérique 15 du cache 13 ménagée entre ledit au moins un récepteur 12 et ledit au moins un émetteur auxiliaire 7 sont de dimensions identiques et de positionnement identique.

Dans un mode de réalisation préféré, le cache 13 comprend un contour 20 ménagé en partie supérieure et le long des parois périphériques 15 du cache 13 de sorte à réduire ladite au moins une ouverture 21 ménagée dans le cache 13 au-dessus dudit au moins un émetteur 5 et ladite au moins une ouverture 22 ménagée dans le cache 13 au-dessus dudit au moins un récepteur 12.

Ainsi, la réduction desdites au moins une ouverture 21, 22 ménagées dans le cache 13 respectivement au-dessus dudit au moins un émetteur 5 et dudit au moins un récepteur 12 permet de renforcer l'immunité au bruit ambiant du dispositif de commande 11 liée à un fort éclairement, en particulier lorsqu'un doigt d'un utilisateur est positionné au-dessus dudit au moins un commutateur optique à touche tactile 4.

Grâce à la présente invention, la paroi périphérique du cache ménagée entre ledit au moins un récepteur et ledit au moins un émetteur auxiliaire comprenant au moins une ouverture de passage d'au moins une partie du rayonnement infrarouge émis par ledit au moins un émetteur auxiliaire vers ledit au moins un récepteur permet de tester le fonctionnement d'au moins un commutateur optique à touche tactile au moyen dudit au moins un émetteur auxiliaire tout en garantissant la détection d'un appui sur ledit au moins un commutateur optique à touche tactile quelles que soient les conditions de luminosité extérieures au dispositif de commande.

Bien entendu, la présente invention n'est pas limitée aux exemples de réalisation décrits précédemment, mais seulement par les revendications.

En particulier, le dispositif de commande d'un appareil électroménager peut être mis en oeuvre dans un autre type de table de cuisson, avec des moyens de chauffage pouvant être du type radiant ou halogène, ou encore au gaz, ou dans un autre type d'appareil de cuisson domestique.

Le dispositif de commande d'un appareil électroménager peut également être mis en oeuvre dans un appareil de lavage domestique, ou dans un appareil de réfrigération domestique.

## Revendications

1. Dispositif de commande (11) d'un appareil électroménager (1) comprenant :
- au moins un commutateur optique à touche tactile (4),
- une paroi (6) étant au moins partiellement transparente à un rayonnement infrarouge ;
ledit au moins un commutateur optique à touche tactile (4) étant disposé derrière ladite paroi (6) au moins partiellement transparente à un rayonnement infrarouge ;
ledit au moins un commutateur optique à touche tactile (4) comprenant :
- au moins un émetteur (5) émettant un rayonnement infrarouge,
- au moins un émetteur auxiliaire (7) émettant un rayonnement infrarouge, et
- au moins un récepteur (12) recevant au moins en partie un rayonnement infrarouge émis par ledit au moins un émetteur (5) et au moins en partie un rayonnement infrarouge émis par ledit au moins un émetteur auxiliaire (7) ;
ledit au moins un récepteur (12) générant au moins un signal de réception en fonction du rayonnement infrarouge reçu depuis ledit au moins un émetteur (5) et/ou depuis ledit au moins un émetteur auxiliaire (7) ;
ledit au moins un émetteur (5) et ledit au moins un récepteur (12) étant disposés dans un cache (13) ;
ledit cache (13) comprenant :
- une paroi de séparation (14) ménagée entre ledit au moins un émetteur (5) et ledit au moins un récepteur (12),
- des parois périphériques (15) ménagées autour dudit au moins un émetteur (5) et dudit au moins un récepteur (12) ;
**caractérisé en ce que** l'une des parois périphériques (15) dudit cache (13) ménagée entre ledit au moins un récepteur (12) et ledit au moins un émetteur auxiliaire (7) formant une cloison de séparation comprend au moins une ouverture de passage (16) d'au moins une partie du rayonnement infrarouge émis par ledit au moins un émetteur auxiliaire (7) vers ledit au moins un récepteur (12) de sorte à déterminer un dysfonctionnement dudit au moins un commutateur optique à touche tactile (4) en fonction dudit au moins un signal de réception reçu par ledit au moins un récepteur (12) depuis ledit au moins un émetteur auxiliaire (7).

2. Dispositif de commande (11) d'un appareil électroménager (1) selon la revendication 1, **caractérisé en ce que** ladite au moins une ouverture de passage (16) de ladite paroi périphérique (15) dudit cache (13) s'étend entre une plaquette de circuit imprimé (17) et un rebord (18) de ladite paroi périphérique (15) dudit cache (13) ménagée entre ledit au moins un récepteur (12) et ledit au moins un émetteur auxiliaire (7), ladite plaquette de circuit imprimé (17) supportant ledit au moins un commutateur optique à touche tactile (4).

3. Dispositif de commande (11) d'un appareil électroménager (1) selon la revendication 2, **caractérisé en ce que** la hauteur de ladite au moins une ouverture de passage de ladite paroi périphérique dudit cache s'étendant depuis ladite plaquette de circuit imprimé jusqu'audit rebord de ladite paroi périphérique dudit cache est supérieure à la hauteur dudit au moins un émetteur auxiliaire s'étendant depuis ladite plaquette de circuit imprimé jusqu'à la face supérieure dudit au moins un émetteur auxiliaire.

4. Dispositif de commande (11) d'un appareil électroménager (1) selon l'une quelconque des revendications 1 à 3, **caractérisé en ce que** ladite au moins une ouverture de passage (16) de ladite paroi périphérique (15) dudit cache (13) s'étend entre deux autres parois périphériques (15) opposées dudit cache (13).

5. Dispositif de commande (11) d'un appareil électroménager (1) selon la revendication 4, **caractérisé en ce que** la largeur de ladite au moins une ouverture de passage (16) de ladite paroi périphérique (15) dudit cache (13) correspond à la distance séparant lesdites deux autres parois périphériques (15) opposées dudit cache (13).

6. Dispositif de commande (11) d'un appareil électroménager (1) selon l'une quelconque des revendications 1 à 5, **caractérisé en ce que** l'épaisseur (e) de ladite paroi périphérique (15) dudit cache (13) comportant ladite au moins une ouverture de passage (16) est inférieure à 1 mm, et préférentiellement de l'ordre de 0,6mm.

7. Dispositif de commande (11) d'un appareil électroménager (1) selon l'une quelconque des revendications 1 à 6, **caractérisé en ce que** les autres parois périphériques (15) dudit cache (13) ménagées entre ledit au moins un récepteur (12) et ledit au moins un émetteur auxiliaire (7) sont pleines.

8. Dispositif de commande (11) d'un appareil électroménager (1) selon l'une quelconque des revendications 1 à 7, **caractérisé en ce que** l'une des parois périphériques (15) dudit cache (13) ménagée autour dudit au moins un émetteur (5) formant une cloison de séparation comprend également au moins une ouverture de passage (19) disposée symétriquement par rapport à ladite au moins une ouverture de passage (16) de ladite paroi périphérique (15) dudit cache (13) ménagée entre ledit au moins un récepteur (12) et ledit au moins un émetteur auxiliaire (7).

9. Dispositif de commande (11) d'un appareil électroménager (1) selon l'une quelconque des revendications 1 à 8, **caractérisé en ce que** ledit au moins un émetteur auxiliaire (7) est disposé en dehors dudit cache (13) comportant ledit au moins un émetteur (5) et ledit au moins un récepteur (12).

10. Appareil électroménager (1), notamment une table de cuisson domestique, **caractérisé en ce que** ledit appareil électroménager (1) comprend un dispositif de commande (11) conforme à l'une quelconque des revendications 1 à 9.

## Patentansprüche

1. Bedienvorrichtung (11) für ein elektrisches Haushaltsgerät (1), umfassend:
- mindestens einen optischen Berührschalter (4),
- eine Wand (6), welche zumindest teilweise für eine Infrarotstrahlung transparent ist;
wobei der besagte mindestens eine optische Berührschalter (4) hinter der besagten, zumindest teilweise für eine Infrarotstrahlung transparenten Wand (6) angeordnet ist; wobei der besagte mindestens eine optische Berührschalter (4) umfasst:
- mindestens einen Strahler (5), welcher eine Infrarotstrahlung emittiert,
- mindestens einen Hilfsstrahler (7), welcher eine Infrarotstrahlung emittiert, und
- mindestens einen Empfänger (12), welcher zumindest teilweise eine von dem besagten mindestens einen Strahler (5) emittierte Infrarotstrahlung und zumindest teilweise eine von dem besagten mindestens einen Hilfsstrahler (7) emittierte Infrarotstrahlung empfängt;
wobei der besagte mindestens eine Empfänger (12) in Abhängigkeit von der von dem besagten mindestens einen Strahler (5) und/oder von dem besagten mindestens einen Hilfsstrahler (7) empfangenen Infrarotstrahlung mindestens ein Empfangssignal erzeugt;
wobei der besagte mindestens eine Strahler (5) und der besagte mindestens eine Empfänger (12) in einer Abdeckung (13) angeordnet sind;
wobei die besagte Abdeckung (13) umfasst:
- eine zwischen dem besagten mindestens einen Strahler (5) und dem besagten mindestens einen Empfänger (12) angebrachte Trennwand (14),
- um den besagten mindestens einen Strahler (5) und den besagten mindestens einen Empfänger (12) herum angebrachte Umfangswände (15);
**dadurch gekennzeichnet, dass** eine der Umfangswände (15) der besagten Abdeckung (13), welche zwischen dem besagten mindestens einen Empfänger (12) und dem besagten mindestens einen Hilfsstrahler (7) angebracht ist und eine Trennwand bildet, mindestens eine Durchgangsöffnung (16) für mindestens einen Teil der von dem besagten mindestens einen Hilfsstrahler (7) an den besagten mindestens einen Empfänger (12) emittierten Infrarotstrahlung umfasst, um in Abhängigkeit von dem besagten mindestens einen Empfangssignal, welches an dem besagten mindestens einen Empfänger (12) von dem besagten mindestens einen Hilfsstrahler (7) empfangen wird, eine Funktionsstörung des besagten mindestens einen optischen Berührschalters (4) zu ermitteln.

2. Bedienvorrichtung (11) für ein elektrisches Haushaltsgerät (1) nach Anspruch 1, **dadurch gekennzeichnet, dass** sich die besagte mindestens eine Durchgangsöffnung (16) der besagten Umfangswand (15) der besagten Abdeckung (13) zwischen einer Leiterplatte (17) und einem Rand (18) der besagten zwischen dem besagten mindestens einen Empfänger (12) und dem besagten mindestens einen Hilfsstrahler (7) angebrachten Umfangswand (15) der besagten Abdeckung (13) erstreckt, wobei die besagte Leiterplatte (17) den besagten mindestens einen optischen Berührschalter (4) unterstützt.

3. Bedienvorrichtung (11) für ein elektrisches Haushaltsgerät (1) nach Anspruch 2, **dadurch gekennzeichnet, dass** die Höhe der besagten mindestens einen Durchgangsöffnung der besagten Umfangswand der besagten Abdeckung, welche sich von der besagten Leiterplatte bis zum Rand der besagten Umfangswand der besagten Abdeckung erstreckt, die Höhe des besagten mindestens einen Hilfsstrahlers, welche sich von der besagten Leiterplatte bis zur Oberseite des besagten mindestens einen Hilfsstrahlers erstreckt, überschreitet.

4. Bedienvorrichtung (11) für ein elektrisches Haushaltsgerät (1) nach einem beliebigen der Ansprüche 1 bis 3, **dadurch gekennzeichnet, dass** sich die besagte mindestens eine Durchgangsöffnung (16) der besagten Umfangswand (15) der besagten Abdeckung (13) zwischen zwei anderen, sich gegenüberliegenden Umfangswänden (15) der besagten Abdeckung (13) erstreckt.

5. Bedienvorrichtung (11) für ein elektrisches Haushaltsgerät (1) nach Anspruch 4, **dadurch gekennzeichnet, dass** die Breite der besagten mindestens einen Durchgangsöffnung (16) der besagten Umfangswand (15) der besagten Abdeckung (13) dem Abstand zwischen den besagten zwei anderen, sich gegenüberliegenden Umfangswänden (15) der besagten Abdeckung (13) entspricht.

6. Bedienvorrichtung (11) für ein elektrisches Haushaltsgerät (1) nach einem beliebigen der Ansprüche 1 bis 5, **dadurch gekennzeichnet, dass** die Stärke (e) der besagten Umfangswand (15) der besagten Abdeckung (13), welche die besagte mindestens eine Durchgangsöffnung (16) aufweist, weniger als 1 mm und vorzugsweise etwa 0,6 mm beträgt.

7. Bedienvorrichtung (11) für ein elektrisches Haushaltsgerät (1) nach einem beliebigen der Ansprüche 1 bis 6, **dadurch gekennzeichnet, dass** die anderen Umfangswände (15) der besagten Abdeckung (13), welche zwischen dem besagten mindestens einen Empfänger (12) und dem besagten mindestens einen Hilfsstrahler (7) angeordnet sind, massiv sind.

8. Bedienvorrichtung (11) für ein elektrisches Haushaltsgerät (1) nach einem beliebigen der Ansprüche 1 bis 7, **dadurch gekennzeichnet, dass** eine der Umfangswände (15) der besagten Abdeckung (13), welche um den besagten mindestens einen Strahler (5) herum angeordnet ist und eine Trennwand bildet, ebenfalls mindestens eine Durchgangsöffnung (19) umfasst, welche symmetrisch zu der besagten mindestens einen Durchgangsöffnung (16) der besagten Umfangswand (15) der besagten Abdeckung (13), welche zwischen dem besagten mindestens einen Empfänger (12) und dem besagten mindestens einen Hilfsstrahler (7) angebracht ist, angeordnet ist.

9. Bedienvorrichtung (11) für ein elektrisches Haushaltsgerät (1) nach einem beliebigen der Ansprüche 1 bis 8, **dadurch gekennzeichnet, dass** der besagte mindestens eine Hilfsstrahler (7) außerhalb der besagten Abdeckung (13), welche den besagten mindestens einen Strahler (5) und den besagten mindestens einen Empfänger (12) enthält, angeordnet ist.

10. Elektrisches Haushaltsgerät (1), insbesondere ein Haushaltskochfeld, **dadurch gekennzeichnet, dass** das besagte elektrische Haushaltsgerät (1) eine Bedienvorrichtung (11) gemäß einem beliebigen der Ansprüche 1 bis 9 umfasst.

## Claims

1. Device (11) for controlling a household electrical appliance (1) comprising:
- at least one touch-operated optical switch (4),
- a wall (6) being at least partly transparent to infrared radiation;
said at least one touch-operated optical switch (4) being disposed behind said wall (6) at least partly transparent to infrared radiation; said at least one touch-operated optical switch (4) comprising:
- at least one emitter (5) emitting infrared radiation,
- at least one auxiliary emitter (7) emitting infrared radiation, and
- at least one receiver (12) at least partially receiving infrared radiation emitted by said at least one emitter (5) and at least partially receiving infrared radiation emitted by said at least one auxiliary emitter (7);
said at least one receiver (12) generating at least one reception signal based on the infrared radiation received from said at least one emitter (5) and/or from said at least one auxiliary emitter (7);
said at least one emitter (5) and said at least one receiver (12) being disposed in a cover (13);
said cover (13) comprising:
- a separating wall (14) between said at least one emitter (5) and said at least one receiver (12),
- peripheral walls (15) around said at least one emitter (5) and said at least one receiver (12);
**characterized in that** one of the peripheral walls (15) of said cover (13) that is between said at least one receiver (12) and said at least one auxiliary emitter (7) forming a separating barrier comprises at least one opening (16) through which at least some of the infrared radiation emitted by said at least one auxiliary emitter (7) can pass through to said at least one receiver (12) in order to determine a malfunction of said at least one touch-operated optical switch (4) based on said at least one reception signal received by said at least one receiver (12) from said at least one auxiliary emitter (7).

2. A device (11) for controlling a household electrical appliance (1) according to claim 1, **characterized in that** said at least one opening (16) of said peripheral wall (15) of said cover (13) extends between a printed circuit board (17) and an edge (18) of said peripheral wall (15) of said cover (13) that is between said at least one receiver (12) and said at least one auxiliary emitter (7), said printed circuit board (17) supporting said at least one touch-operated optical switch (4).

3. A device (11) for operating a household electrical appliance (1) according to claim 2, **characterized in that** the height of said at least one opening of said peripheral wall of said cover extending from said printed circuit board to said edge of said peripheral wall of said cover is greater than the height of said at least one auxiliary emitter extending from said printed circuit board to the upper side of said at least auxiliary emitter.

4. A device (11) for operating a household electrical appliance (1) according to any one of the claims 1 to 3, **characterized in that** said at least one opening (16) of said peripheral wall (15) of said cover (13) extends between two other peripheral walls (15) of said cover (13) opposite one another.

5. A device (11) for operating a household electrical appliance (1) according to claim 4, **characterized in that** the width of said at least one opening (16) of said peripheral wall (15) of said cover (13) corresponds to the distance separating said two other peripheral walls (15) of said cover (13) opposite one another.

6. A device (11) for operating a household electrical appliance (1) according to any one of the claims 1 to 5, **characterized in that** the thickness (e) of said peripheral wall (15) of said cover (13) comprising said at least one opening (16) is less than 1 mm, and preferentially on the order of 0.6 mm.

7. A device (11) for operating a household electrical appliance (1) according to any one of the claims 1 to 6, **characterized in that** the other peripheral walls (15) of said cover (13) that are between said at least one receiver (12) and said at least one auxiliary emitter (7) are solid.

8. A device (11) for operating a household electrical appliance (1) according to any one of the claims 1 to 7, **characterized in that** one of the peripheral walls (15) of said cover (13) that are around said at least one emitter (5) forming a separation barrier also comprises at least one opening (19) symmetrically disposed with respect to said at least one opening (16) of said peripheral wall (15) of said cover (13) that is between said at least one receiver (12) and said at least one auxiliary emitter (7).

9. A device (11) for operating a household electrical appliance (1) according to any one of the claims 1 to 8, **characterized in that** said at least one auxiliary emitter (7) is disposed outside of said cover (13) comprising said at least one emitter (5) and said at least one receiver (12).

10. A household electrical appliance (1), in particular a home cooking hob, **characterized in that** said household electrical appliance (1) comprises a control device (11) according to any one of the claims 1 to 9.
